# EUROPEAN PATENT APPLICATION

(11) **EP 4 654 770 A1**
(43) Date of publication of application: **26.11.2025**
(21) Application number: 24176905.8
(22) Date of filing: 20.05.2024
(51) Int. Cl.: H05K 9/00

(54) **ELECTROMAGNETICALLY SHIELDED ELECTRONICS CRATE**

(71) Applicant: Target Enclosure AB, 751 34 Nässjö (SE)
(72) Inventor: Johansson, Hans-Erik, 335 32 Gnosjö (SE)
(74) Representative: AWA Sweden AB

(57) **Abstract**

A TEMPEST-grade electromagnetically shielded electronics crate (10) comprises a body (20) and a drawer (30). The drawer is arranged to be locked by a latch mechanism (70) and a locking bolt (52). The locking bolt (52) is configured to engage with two openings (36; 46) which, in the locked state line up with said locking bolt (52).

## Description

### Field of the invention

The present inventive concept relates to a TEMPEST-grade electromagnetically shielded electronics crate.

### Background

Many security aspects need to be taken into account when dealing with high-security crates for electronic equipment. The electronic equipment may need to be protected from collisions with objects outside the enclosure. The electronic equipment may need protection from external electromagnetic radiation. Signals within the enclosure may need to be shielded off as to not be observable from the outside. For this application, standards, usually referred to using the term "TEMPEST", are established that require attenuation up to the order of 100 dB at frequencies up to 10 GHz within the crate. Furthermore, the enclosure may have to prevent malicious parties from physically breaking in and accessing/damaging the electronic equipment. There is always a need to improve the security of crates for electronic equipment.

### Summary

It is an object of the present inventive concept to provide a solution to at least some of the above challenges.

According to the present inventive concept, and, according to a first aspect, there is provided a TEMPEST-grade electromagnetically shielded electronics crate, comprising a body comprising a plurality of side walls; a locking mechanism for locking said crate, said locking mechanism comprising a locking bolt, a drawer arranged linearly movably with respect to said body, said drawer comprising a front plate for closing and electromagnetically sealing said crate; and a movable frame provided with a first opening matching said locking bolt and arranged to slide along one of said plurality of side walls of said body; and a linear motion mechanism arranged to drive a linear motion of said drawer with respect to said body, said linear motion mechanism comprising a driving member, said linear motion mechanism being configured to drive said linear motion through actuation of said driving member, and a locking rod rigidly connected to said driving member, said locking rod having a second opening matching said locking bolt, wherein said drawer and said linear motion mechanism are arranged so that, with said drawer in a position where said front plate closes and seals said crate, said first opening and said second opening line up at said locking bolt for closing said locking mechanism.

Having a locking bolt with two corresponding openings may provide extra security through redundance and interlocking. Since the openings may move in relation to the locking bolt, but line up with when the front plate closes and seals the crate, the locking mechanism may be prevented from being activated in a state where the front plate is open. Having the locking bolt engage with two openings wherein each opening is connected to a different part of the crate may provide additional resistance against a brute force attack.

The locking mechanism may further comprise a locking lever operable from outside said crate, wherein said locking lever is connected to said body at a pivot point and said locking lever is connected to said locking bolt at a connection point, wherein said connection point is pivoted with respect to said pivot point and movable with respect to said body for moving said locking bolt for closing said locking mechanism.

The locking lever may reduce the force needed to operate the locking mechanism through mechanical leverage. Having the locking mechanism being operable from the outside of the crate through the locking lever allows the locking mechanism to be located inside the crate where it is hidden and protected from being damaged. This may improve security of the crate since it prevents malicious parties from studying the locking mechanism. Having the locking mechanism inside the crate may also prevent malicious parties from breaking the locking mechanism.

The locking mechanism may further comprise a lock for locking said locking lever, said lock may be located at a periphery of said crate. Having a lock for locking said locking lever may prevent malicious parties from maneuvering the locking lever and opening the crate. Having the lock for the locking lever located at a periphery of said crate as opposed to a location closer to the connection point inside the crate may provide larger mechanical counter-leverage blocking the movement of the locking lever. This may prevent a malicious party from using leverage from the locking lever to break the lock for the locking lever.

The linear motion mechanism may further comprise a driving member provided slidably suspended either at said movable frame or at said body; and a guiding track provided at the other of said movable frame or said body, wherein said driving member is configured to engage with said guiding track for driving the linear motion upon actuation of said driving member.

The guiding track may direct the movement of the movable frame in relation to the body in response to actuating said driving member, this may reduce friction between the movable frame and the body. The guiding track may enable translation of the movement of the driving member to movement of the moveable frame in relation of the body. The guiding track may enable the driving member to move in a different direction compared to the movement of the moveable frame in relation to the body.

The driving member may be arranged to move in a direction substantially perpendicular to the direction of said linear movement. Having the driving member move in a substantially perpendicular direction to said linear movement may provide additional security against brute force attacks. In the locked state, the locking bolt engages with a first opening in the movable frame and a second opening in the locking rod rigidly connected to the driving member. The locking bolt may prevent the linear movement of the movable frame by engaging with the first opening. The locking bolt may prevent movement of the driving member by engaging with the second opening. A malicious party trying to open the drawer with brute force would need to overcome large locking forces in two directions simultaneously which may improve security.

Said linear motion mechanism may be a first linear motion mechanism and said locking bolt may a first locking bolt, said crate further comprising a second linear motion mechanism located at an opposite end of said crate in relation to said first linear motion mechanism, said locking mechanism comprising a second locking bolt rigidly connected to said first locking bolt for locking said second linear motion mechanism.

Having the locking bolts be rigidly connected to each other may allow them to cooperate against a malicious party trying to engage one linear motion mechanism by brute force. Both locking bolts may engage with their corresponding openings and provide significant additional resistance in response to such an attack.

The first locking bolt and said second locking bolt may be located on a substantially U-shaped member connected to said connection point pivoted with respect to said connection point.

An advantage of having the first and second locking bolts on a substantially U-shaped member connected to said connection point pivoted with respect to the connection point may be that both locking bolts may be operated by a single locking lever. This may save material and facilitate manufacture. A further advantage of this configuration may be mitigation of the human factor in that an authorized user can't engage a locking mechanism corresponding to an open drawer since the lever may not be moved toward the locked state. This may mitigate the risk of an authorized user forgetting to close one side of the crate before engaging the locking mechanisms.

Said crate may further comprise a latch mechanism, said latch mechanism further comprising a connecting member connected to said connection point, a latch hook extending from said front plate, at an end opposite said end associated with said locking bolt, or located on said connecting member, a latch slot located at the other of said front plate at an end opposite associated with said locking bolt or on said connecting member, configured to receive said latch hook in a first, locked state, said latch hook and said latch slot being configured to disengage in a second, unlocked state, said latch hook and said latch slot being moveably arranged with respect to each other in response to movement of said locking lever.

An advantage of this latch mechanism is that it may provide additional protection against malicious parties breaking into the crate. In particular it may prevent a malicious party from forcibly wedging a tool such as a crowbar between the front plate and the body of the crate at the front plates "exposed end", the end not associated with the locking bolt, and prying open the front plate. Having the latch mechanism connected to the same connection point as the locking bolt may enable simultaneous operation of both the latch mechanism and the locking bolts.

Said latch hook may be a first latch hook and said latch slot may be a first latch slot, said latch mechanism may further comprise a second latch hook and a second latch slot, configured to engage with each other, said second latch hook and said second latch slot are located at the opposite end of said crate in relation to said first latch hook and said first latch slot, wherein said latch hook is located on said connecting member or on a rear plate at an opposite end of said crate in relation to said front plate and said latch slot is located on the other of said connecting member or said rear plate.

An advantage of this configuration may be that both latch pairs cooperate which may provide additional resistance against e.g. said crow-bar attack mentioned above. Both latch pairs are connected to each other through the connecting member as well as to a corresponding front and rear plate, respectively, this means that an attack aiming to pry open one plate may cause the other plate to be pushed against said body of said crate in response to said attack, whereby significant additional resistance may be provided.

Said connecting member may be substantially T-shaped. An advantage of having a substantially T-shaped connecting member, may be that it provides a first portion efficiently connecting both latch-pairs. This may enable advantageous cooperation between said latch pairs which may improve the durability of the crate and may improve resistance against attacks. Further, the T-shaped connecting member may provide a second portion connecting said first portion to the connection point, which may enable efficient operation of the latch pairs by the locking lever connected to said connection point.

One of said body and said front (or rear plate) may be provided with an electromagnetically-sealing gasket and the other of said body and said front plate (or said rear plate) may be provided with an edge fitting into said gasket, for electromagnetically sealing said front plate to said body.

An advantage of installing an electromagnetically sealing gasket between the body and the front or rear plate may be that it prevents electromagnetic radiation from leaking out of the crate. This may in turn prevent malicious parties from observing signals originating from inside the crate. The gasket may also prevent malicious parties from sending electromagnetic waves into the crate. The gasket may further protect electronic equipment inside the crate from damage from high-intensity electromagnetic pulses.

Said guiding track may have a variable slope along said guiding track. Having a variable slope along said guiding track may help in translating movement of the driving member to movement of the frame in relation to the body. An advantage of having a variable slope may be that the force the user needs to apply at the driving member can be fine-tuned for different parts of the movement of the driving member.

### Brief description of the drawings

The above, as well as additional objects, features and advantages of the present inventive concept, will be better understood through the following illustrative and non-limiting detailed description of preferred embodiments, with reference to the appended drawings, where the same reference numerals will be used for similar elements, wherein:
Fig. 1a shows a crate vertically mounted in a rack, in its casing.
Fig. 1b shows four crates in their casing horizontally stacked on top of each other.
Fig. 2 shows a bottom view of a crate separated from its casing.
Fig. 3a shows a perspective view of the front and bottom sides of the crate, where the front plate is closed and the handle is in an active position.
Fig. 3b shows a perspective view of the front and bottom sides of the crate, where the front plate is ajar and the handle is in a passive position.
Fig. 3c shows a perspective view of the front and bottom sides of the crate, where the front plate is open and the handle is in a passive position.
Fig. 4a shows a perspective view of a side of the crate associated with the locking bolt and the latch mechanism as seen from a slight rear-facing angle, where the locking lever is in a locking position.
Fig. 4b shows a perspective view of a side of the crate associated with the locking bolt and the latch mechanism as seen from a slight rear-facing angle, where the locking lever is in a position associated with the unlocked state.
Fig. 5a shows a perspective view of a side of the crate associated with the locking bolt and the latch mechanism as seen from a front-facing angle. The locking lever is in a locking position.
Fig. 5b shows a perspective view of a side of the crate associated with the locking bolt and the latch mechanism as seen from a front-facing angle. The locking lever is in a position associated with the open state.
Fig. 6a shows a perspective view of the crate showing the side associated with the linear motion mechanism, as well as the side associated with the locking bolt and the latch mechanism. These sides are viewed from a slight rear-facing angle. The locking lever is in a position associated with the locked state. The front plate and the rear plate are closed.
Fig. 6b shows a perspective view of the crate showing the side associated with the linear motion mechanism, as well as the side associated with the locking bolt and the latch mechanism. These sides are viewed from a slight rear-facing angle. The locking lever is in a position associated with the unlocked state. The front plate and the rear plate are open.
Fig. 7 shows an electromagnetically sealing gasket located on a rear plate of the crate.

### Detailed description of the exemplary embodiments

A TEMPEST-grade electromagnetically shielded electronics crate 10 will now be described with reference to the figures.

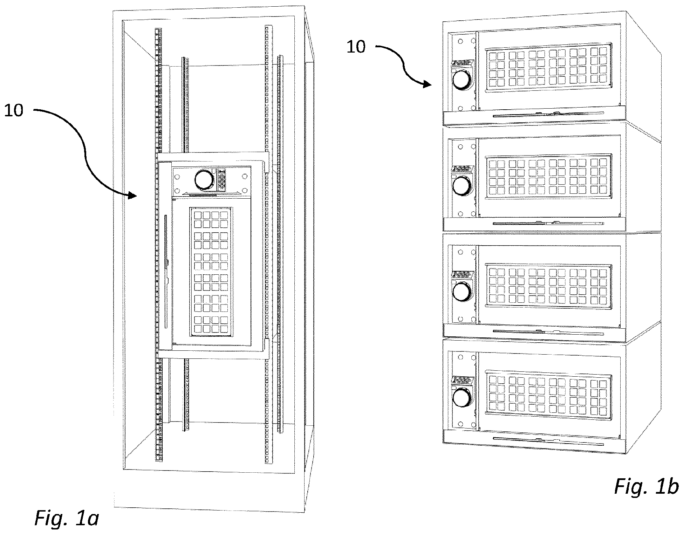

Fig.1a shows an example of how the crate 10 can be mounted. The crate 10 is mounted in a vertical orientation on a mounting rack inside an electronics cabinet. Fig. 1b shows another example of how the crate 10 can be mounted. The crate 10 can be horizontally mounted on top of other, similar TEMPEST-grade electromagnetically shielded electronics crates as to form a stack of crates. When the crate is mounted and securely fastened in said casing 12, mechanisms located on the periphery of said crate are hidden, inaccessible and protected from the outside environment.

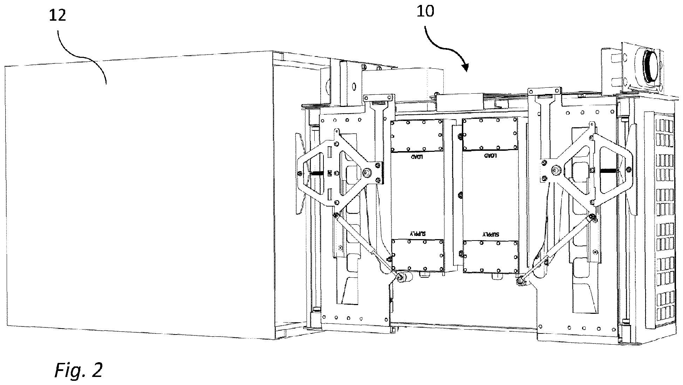

Fig.2 shows a bottom view of the crate 10, separated from its casing 12. The front plate 32, parts of the locking mechanism 50, the front handle 48 and the rear handle 48' are visible and accessible from the outside.

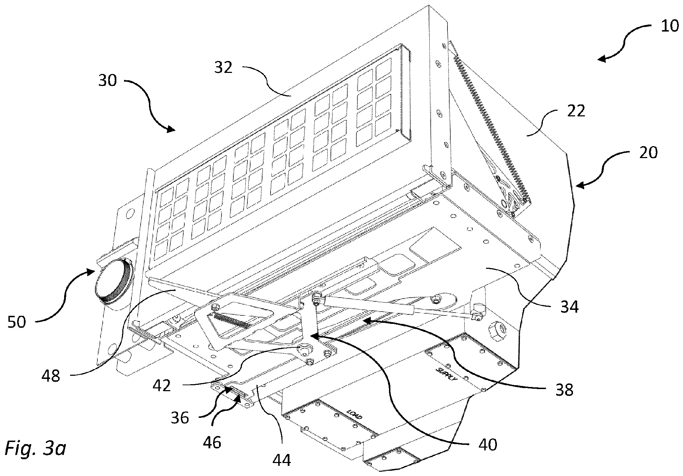

Fig. 3a shows a perspective view of the front and bottom sides of the crate 10. The crate 10 comprises a body 20 having a plurality of side walls 22. The crate comprises a locking mechanism 50 for locking said crate, said locking mechanism 50 comprising a locking bolt 52 (not visible in this figure, cf. below). The crate comprises a drawer 30 arranged linearly moveable with respect to said body 20, said drawer 30 comprising, a front plate 32 for closing and electromagnetically sealing said crate; and a moveable frame 34 provided with a first opening 36 matching said locking bolt 52 and arranged to slide along one of said plurality of side walls 22 of said body 20. The crate 10 comprises a linear motion mechanism 40 arranged to drive a linear motion of said drawer 30 with respect to said body 20, said linear motion mechanism 40 comprising: a driving member 42, said linear motion mechanism 40 being configured to drive said linear motion through actuation of said driving member 42, and a locking rod 44 rigidly connected to said driving member 42, said locking rod 44 having a second opening 46 matching said locking bolt 52 (cf. below). The crate is in a closed state and the handle 48 is in an active position, where said handle 48 can be used to engage the linear motion mechanism 40.The driving member 42 is located at a position within the guiding track 38 associated with the crate's closed state. The moveable frame 34 is in a position associated with the crate's 10 closed state. The opening 36 provided in the moveable frame 34 is positioned as to line up with the locking bolt 52 (cf. below). The opening 46 provided in the locking rod 44 of the linear motion mechanism 40 is positioned as to line up with the locking bolt 52. Thus, when said drawer 30 and said linear motion mechanism 40 are arranged so that, with said drawer 30 in a position where said front plate 32 closes and seals said crate 10, said first opening 36 and said second opening 46 at said locking bolt 52 for closing said mechanism.

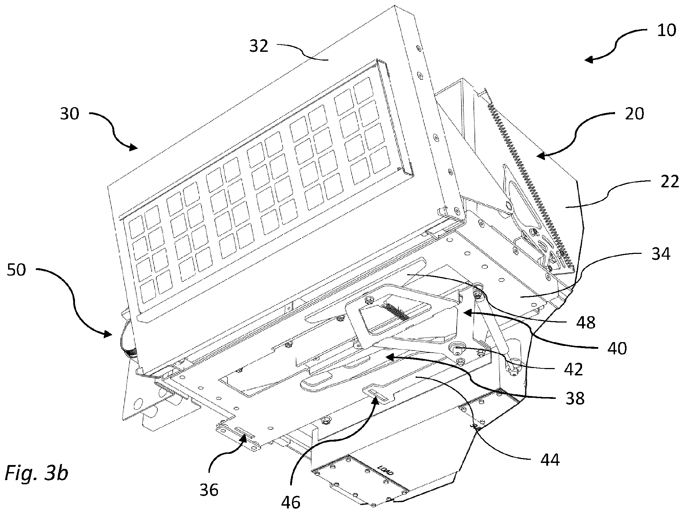

Fig. 3b shows a perspective view of the front and bottom sides of the crate 10. The front plate 32 of the crate is ajar and the handle 48 is in a passive position corresponding to when the handle 48 is not configured to engage the linear motion mechanism. The driving member 42 slidably suspended at a position within the guiding track 38 of said movable frame associated with the crate's open state. The moveable frame 34 is in a position associated with the crate's 10 open state, corresponding to a linear shift in a forward direction in this embodiment. The opening 36 provided in the moveable frame 34 is positioned as to not line up with the locking bolt 52 as a result of the linear forward shift. The opening 46 provided in the locking rod 44 is positioned as to not line up with the locking bolt 52. The direction of the movement of the locking rod 44 and the driving member 42 between the crate's 10 open state and closed state is substantially perpendicular to the linear shift movement of the moveable frame.

Thus a crate 10 wherein said driving member 42 is slidably suspended either at said movable frame 34 or at said body 20, and said linear motion mechanism 40 further comprises a guiding track 38 at the other of said movable frame or said body, wherein said driving member 42 is configured to engage with said guiding track 38 for driving the linear motion upon actuation of said driving member 42 is shown.

Further, it is shown that said driving member 42 is arranged to move in a direction substantially perpendicular to the direction of said linear movement.

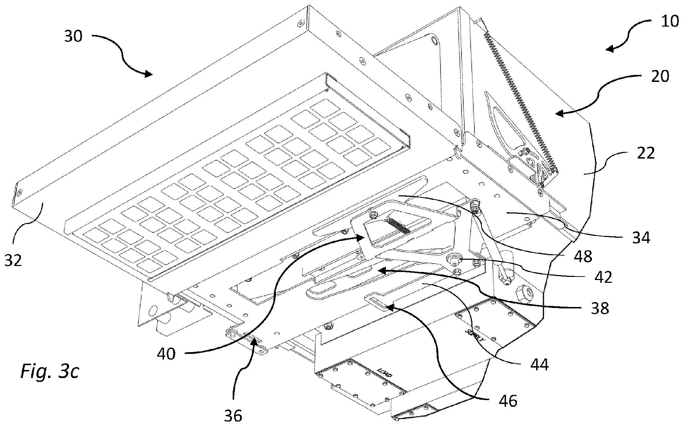

Fig. 3c shows a perspective view of the front and bottom sides of the crate 10. The front plate 32 of the crate 10 is open and the handle 48 is in a passive position. The driving member 42 is located at a position within the guiding track 38 associated with the crate's 10 open state. The guiding track 38 has a variable slope along said guiding track. The variable slope of the guiding track 38 connects a position within the guiding track 38 associated with the crate's open state to a position within the guiding track 38 associated with the crates closed state. The moveable frame 34 is in a position associated with the crate's 10 open state, corresponding to a linear shift in an outward direction in this embodiment. The opening 36 provided in the moveable frame 34 is positioned as to not line up with the locking bolt 52 . The opening 46 provided in the locking rod 44 is positioned as to not line up with the locking bolt 52.

Thus, a crate 10 wherein said guiding track 38 has a variable slope along said guiding track 38 is shown.

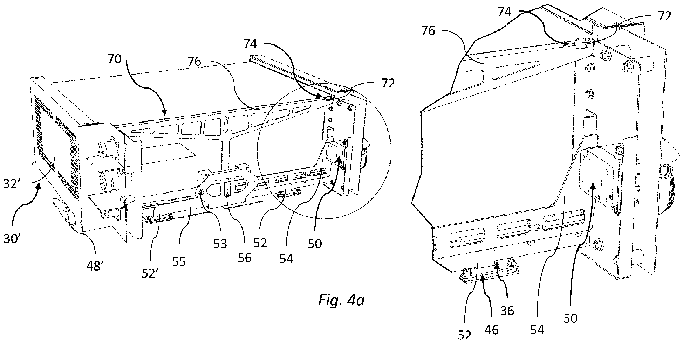

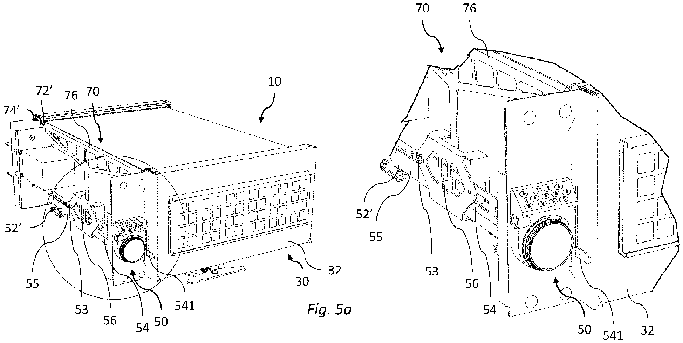

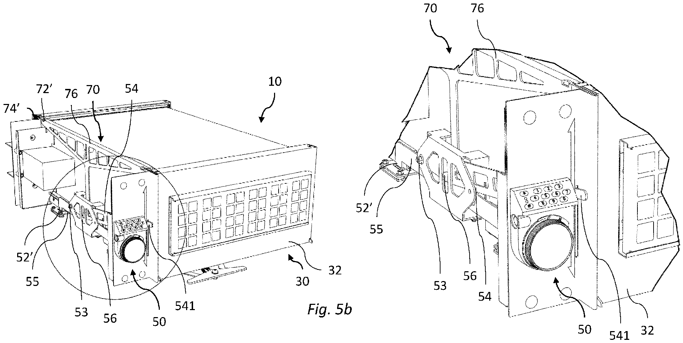

Fig. 4a shows a perspective view of a side of the crate 10 associated with the locking bolt 52 and the latch mechanism 70 as seen from a slight rear-facing angle. The crate 10 is shown in its locked state. The locking lever 54 is in a position associated with the locked state. The locking lever 54 has a portion 541 protruding (not visible in this figure, see e.g. Fig 5a, Fig 5b) out through the front plate 32. The locking lever 54 is connected to the body 20 at a pivot point 53. The locking mechanism 50 prevents movement of the locking lever 54 to a position associated with the unlocked state. The locking bolts 52,52' are located on a member, 55, said member 55 is connected to the locking lever at a connection point 56. The embodiment has linear motion mechanisms 40, 40' (not visible in this figure, cf., e.g. Fig 3a, Fig 3b, Fig 3c) and moveable frames 34, 34' (not visible in this figure, cf., e.g. Fig 3a, Fig 3b, Fig 3c) associated with both the front side and the rear side. The locking bolts 52, 52' respectively engage with the openings 36, 36' provided in the moveable frames 34, 34' and the openings provided in the locking rod 46,46' of both the front and rear sides. The latch mechanism 70 is connected to the locking lever 54 at a connection point 56. The latch mechanism 70 engages with both the front plate 32 and the rear plate 32'. In this embodiment the latch slot 74, is located on the connecting member 76 and the latch hook 72 is located on the front plate 32, however it shall be noted that an opposite configuration of this first latch hook 72-latch slot 74 pair is also possible, where the latch hook 72, is located on the connecting member 76 and the latch slot 74 is located in the front plate 32. Both corresponding configurations of the latch hook 72' and latch slot 74' are also possible for the portion of the latch mechanism 70 associated with the rear plate 32'. The latch hooks 72, 72' and latch slots 74, 74' of both the front plate 32 and the rear plate 32', respectively, are located at an area opposite the locking bolt 52 52' of the corresponding side. As the skilled person would readily contemplate, a crate 10 having only one locking bolt 52 is equally possible.

Thus, said locking mechanism 50 further comprises a locking lever 54 operable from the outside (by movement of the protruding portion 541 of the locking lever 54) said crate 10, wherein said locking lever 54 is connected to said body 20 at a pivot point 53 and said locking lever 54 is connected to said locking bolt 52 52' at a connection point 56, said connection point 56 is pivoted with respect to said pivot point 53 and movable with respect to said body 20 for moving said locking bolt 55 52 52' for closing said locking mechanism 50.

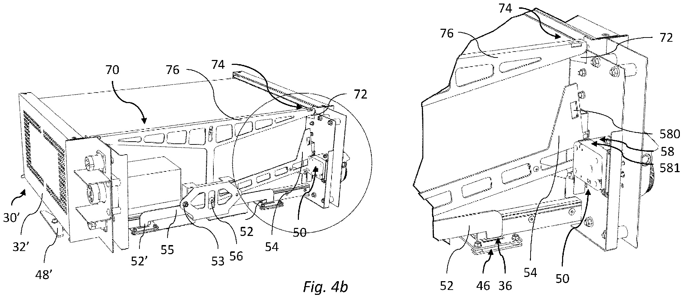

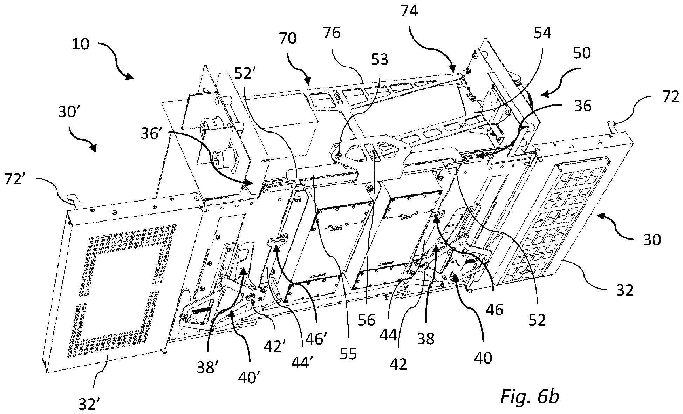

Further, a crate 10 comprising a latch mechanism 70, said latch mechanism further comprising a connecting member 76 connected to said connection point 56, a latch hook 72 extending from said front plate 32, at an end opposite the end associated with said locking bolt 52 or located on said connecting member 76, a latch slot 74 located on one of the other of said front plate 32 at an end opposite said end associated with said locking bolt 52 or said connecting member 76, said latch slot 74 configured to receive said latch hook 72 in a first, locked state, said latch hook 72 and said latch slot 74 configured to disengage in a second, unlocked state, (see Fig. 4b, Fig 6b) said latch hook 72 and said latch slot 74 being moveably arranged with respect to each other in response to movement of said locking lever 54 is shown.

Fig. 4b shows the same crate 10 as shown in Fig. 4a, from the same perspective. The crate 10 is shown in its unlocked state. The locking lever 54 is in a position associated with the unlocked state. The locking lever 54 has a portion 541 (not visible in this figure) protruding out through the front plate 32 (cf., e.g., Fig 3a, Fig 3b, Fig 3c) and operable from the outside of said crate. The locking mechanism 50 does not prevent movement of the locking lever. The locking mechanism comprises a lock 58 for locking said lever 54 located at a periphery of said crate (in this embodiment, in close proximity to the front plate 32). In this embodiment the lock 58 consists of a locking peg 581 (not visible in this figure) in connection to said locking mechanism 50 and a hole 580 in the locking lever 54 configured to receive said locking peg 581 in a first locked state. In the locked state, the locking peg 581 prevents movement of the locking lever 54. It should be noted that other variations of locks are possible for this application as readily appreciated by the person skilled in the art. The connection point 56 to which the locking bolts 52 52' and the latch mechanism 70 are connected has moved in comparison to the locked state shown in Fig.4a. The locking bolts 52, 52' have moved in comparison to the locked state shown in Fig.4a, to a position where they do not engage with the corresponding openings 36, 36' provided in the movable frames 34, 34' and the corresponding openings 46, 46' provided in the locking rods 44, 44' associated with both the front plate 32 and the rear plate 32'. The latch mechanism 70 has moved in comparison to the state shown in Fig.4a, to a position where the hook 72 72'- slot 74 74' pairs of the front side and the rear side do not engage with each other. The handle 48' associated with the rear plate 32' is in a position associated with the closed state.

Thus said locking mechanism 50 further comprises a lock 58 for locking said locking lever, said lock located at a periphery of said crate.

Fig. 5a shows a perspective view of a side of the crate 10 associated with the locking bolts 52, 52' and the latch mechanism 70 as seen from a front-facing angle. The latch mechanism 70 comprises a second latch hook 72'- latch slot 74' pair at a location associated with the crate's rear side, opposite said first latch hook 72- latch slot 74 pair.

A portion 541 of the locking lever protrudes through a slot in the front plate 32. The locking lever 54 is in a position associated with the locked state. The locking mechanism 50 prevents the locking lever 54 to be moved to a position associated with the unlocked state. The locking bolts 52 52' and the latch mechanism 70 are in the same configuration as described in view of Fig.4a. The handle 48 associated with the front plate 32 is in a passive position associated with the closed state.

Thus, a crate 10 wherein said latch hook 72 is a first latch hook 72 and said latch slot 74 is a first latch slot 74, said latch mechanism 70 further comprising a second latch hook 72' and a second latch slot 74' configured to engage with each other, said second latch hook 72' and said second latch slot 74' are located at the opposite end of said crate 10 in relation to said first latch hook 72 and said first latch slot 74, wherein said second latch hook 72' is located on said connecting member 76 or extends from a rear plate 32', at an opposite end of said crate 10 in relation to said front plate 32 and said second latch slot 74' is located on one of the other of said connecting member 76 or said rear plate 32' is shown.

Fig. 5b shows the same crate as in Fig. 5a, from the same perspective. The locking lever 54 and the protruding portion 541 are in a position associated with the unlocked state. The locking mechanism 50 does not prevent movement of the locking lever 54. The locking bolts 52, 52' and the latch mechanism 70 are in the same configuration as described in view of Fig.4b. The connecting member is substantially T- shaped. The handle 48 associated with the front plate 32 is in a passive position associated with the closed state.

Thus, a crate 10 wherein said connecting member 76 is substantially T-shaped is shown.

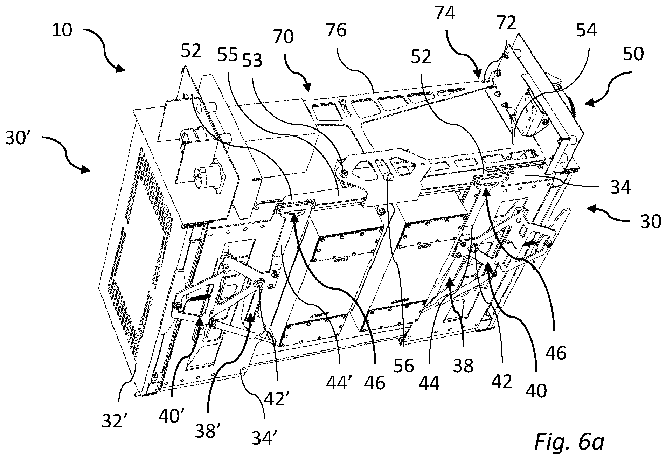

Fig. 6a shows a perspective view of the crate 10 showing the side associated with the linear motion mechanisms 40, 40', (the bottom side in this embodiment,) as well as the side associated with the locking lever 54, the locking bolts 52 52' and the latch mechanism 70. These sides are viewed from a slight rear-facing angle. Fig 6a shows a corresponding movable frame 34' associated with the rear side of the crate 10 corresponding to the movable frame 34 associated with the crate's 10 front side shown in Fig.3a, Fig. 3b, and Fig. 3c. A corresponding linear motion mechanism 40' for said movable frame 34' associated with the rear side of the crate 10 is shown. The locking bolt 52 comprises a second locking bolt 52' associated with the crate's 10 rear side, said second locking bolt 52' and said first locking bolt 52 are rigidly connected to each other via a member 55. The locking bolts 52 52' are connected to the locking lever 54 via a connection point 56. The locking lever 54 is in a position associated with the locked state. The locking mechanism 50 prevents movement of the locking lever 54 to the unlocked state. The configuration of the latch mechanism 70, the locking bolts 52, 52', the openings 36, 36' provided in the moveable frames 34, 34' and the openings 46, 46' provided locking rods 44, 44' of the front and the rear sides are the same as described in view of Fig. 4a.

Thus, a crate 10 where said linear motion mechanism 34 is a first linear motion mechanism 34 and said locking bolt 52 is a first locking bolt 52, said crate 10 further comprising a second linear motion mechanism 34' located at an opposite end of said crate in relation to said first linear motion mechanism 34, and said locking mechanism 50 comprises a second locking bolt 52' rigidly connected to said first locking bolt 52 (through member 55), for locking said second linear motion mechanism 34' is shown.

Fig. 6b shows the same crate 10 as in 6a, from the same perspective. The locking lever 54 is in a position associated with the unlocked state. The locking mechanism 50 does not prevent movement of the locking lever 54. The locking bolts 52, 52' connected to the locking lever 54 (through member 55) at said connection point 56 pivoted with respect to said pivot point 53 has moved compared to the locked state shown in Fig. 6a. The locking bolts 52 52' do not engage with any of the corresponding openings 36 36' provided in the moveable frames 34, 34' or the corresponding openings 46, 46' provided in the locking rods 44, 44' associated with the front plate 32 or the rear plate 32'. The member 55 of the locking bolts 52, 52' is substantially U-shaped. The moveable frames 34 34' have moved compared to the state shown in Fig. 6a and the openings 36, 36' provided in said movable frames 34, 34' do not line up with the locking bolts 52, 52'. The locking rods 44, 44' of the linear motion mechanisms 40, 40' have moved compared to the state shown in Fig.6a. The locking rods 44, 44' of the linear motion mechanisms 40, 40' no longer line up in relation to the corresponding locking bolts 52, 52'. The latch mechanism 70 connected to the locking lever 54 has moved in comparison to the state described in Fig.6a. The hook -slot pairs respectively associated with the front plate 72, 74 and the rear plate 72', 74' are disengaged. The handle of the rear plate 48' and the handle of the front plate 48 are in positions associated with the open state, respectively. The driving members 42, 42' respectively associated with the front 32 and rear plates 32' are in a position within their respective guiding tracks 38, 38' associated with the open state. The front plate 32 and the rear plate 32' are in an open state. The inside of the crate is accessible.

Thus, a crate 10 wherein said first locking bolt 52 and said second locking bolt 52' are located on a substantially U-shaped member 55 connected to said connection point 56 pivoted with respect to said pivot point 53 is shown.

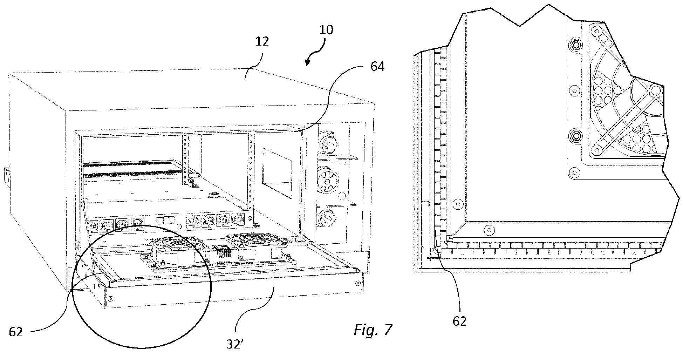

Fig.7 is a perspective view of the crate 10 within its casing 12. The crate 10 is shown in its open state from a substantially rear-facing angle. An electromagnetically sealing gasket 62 is shown on the rear plate 32'. An edge 64 matching said electromagnetically sealing gasket 62 is provided at the on the body of said crate, such that said edge 64 and said electromagnetically sealing gasket 62 engage with each other in the crate's closed state as to electromagnetically seal said crate 10. It is noted that an opposite arrangement of the gasket 62 and edge 64 is possible, where the edge 64 is located on the rear plate 32' and the electromagnetically sealing gasket 62 is mounted on the crate's body 10. A similar gasket 62 - edge 64 pair (not visible) is mounted on the side of the crate's body associated with the front plate and the front plate respectively. It is noted that an opposite arrangement of the gasket and edge, (as described in view of the rear plate) is possible for the gasket-edge pair associated with the front plate.

Thus, there is provided a crate, wherein said front plate, or said rear plate being provided with an electromagnetically-sealing gasket 62 and the other of said body and said front plate or said rear plate being provided with an edge 64 fitting into said gasket 62, for electromagnetically sealing said front plate to said body.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

## Claims

1. A TEMPEST-grade electromagnetically shielded electronics crate (10), comprising:
a body (20) comprising a plurality of side walls (22);
a locking mechanism (50) for locking said crate (10), said locking mechanism (50) comprising a locking bolt (52),
a drawer (30) arranged linearly movably with respect to said body (20), said drawer(30) comprising:
a front plate (32) for closing and electromagnetically sealing said crate (10); and
a movable frame (34) provided with a first opening (36) matching said locking bolt (52) and arranged to slide along one of said plurality of side walls (22) of said body (20); and
a linear motion mechanism (40) arranged to drive a linear motion of said drawer (30) with respect to said body (20), said linear motion mechanism (40) comprising:
a driving member (42), said linear motion mechanism (40) being configured to drive said linear motion through actuation of said driving member (42), and
a locking rod (44) rigidly connected to said driving member (42), said locking rod (44) having a second opening (46) matching said locking bolt (52),
wherein said drawer (30) and said linear motion mechanism (40) are arranged so that, with said drawer (30) in a position where said front plate (32) closes and seals said crate (10), said first opening (36) and said second opening (46) line up at said locking bolt (52) for closing said locking mechanism (50).

2. The crate of claim 1, wherein said locking mechanism (50) further comprises a locking lever (54; 541) operable from outside said crate (10), wherein said locking lever (54) is connected to said body (20) at a pivot point (53) and said locking lever (54) is connected to said locking bolt (52) at a connection point (56), wherein said connection point (56) is pivoted with respect to said pivot point (53) and movable with respect to said body (20) for moving said locking bolt (52) for closing said locking mechanism (50).

3. The crate (10) of claim 2, said locking mechanism (50) further comprising a lock (58) for locking said locking lever (54), said lock (58) located at a periphery of said crate (10).

4. The crate (10) of any one of claims 1-3, wherein :
said driving member (42) is slidably suspended either at said movable frame (34) or at said body (20), and said linear motion mechanism (40) further comprises
a guiding track (38) provided at the other of said movable frame (34) or said body (20),
wherein said driving member (42) is configured to engage with said guiding track (38) for driving the linear motion upon actuation of said driving member (42).

5. The crate (10) of any one of claims 1-4, wherein said driving member (42) is arranged to move in a direction substantially perpendicular to the direction of said linear movement.

6. The crate (10) of any one of claims 1-5, wherein said linear motion mechanism (40) is a first linear motion mechanism (40) and said locking bolt (52) is a first locking bolt (52), said crate (10) further comprising a second linear motion mechanism (40') located at an opposite end of said crate (10) in relation to said first linear motion mechanism (40), and said locking mechanism (50) comprises a second locking bolt (52') rigidly connected to said first locking bolt (52) for locking said second linear motion mechanism (40').

7. The crate (10) of any one of claims 2-6 , wherein said first locking bolt (52) and said second locking bolt (52') are located on a substantially U-shaped member (55) connected to said connection point (56) pivoted with respect to said pivot point (53).

8. The crate (10) of any one of claims 2-7 further comprising:
a latch mechanism (70), said latch mechanism (70) further comprising
a connecting member (76) connected to said connection point (56),
a latch hook (72) extending from said front plate (32), at an end opposite the end associated with said locking bolt (52), or located on said connecting member (76),
a latch slot (74) located on one of the other of said front plate (32) at an end opposite said end associated with said locking bolt (52) or said connecting member (76)
wherein said latch slot (74) is configured to receive said latch hook (72) in a first, locked state, said latch hook (72) and said latch slot (74) are configured to disengage in a second, unlocked state, and said latch hook (72) and said latch slot (74) being moveably arranged with respect to each other in response to movement of said locking lever (54).

9. The crate (10) according to claim 8 wherein said latch hook (72) is a first latch hook (72) and said latch slot (74) is a first latch slot (74) , said latch mechanism (70) further comprising:
a second latch hook (72') and,
a second latch slot (74') configured to engage with each other, said second latch hook (72') and said second latch slot (74') are located at the opposite end of said crate (10) in relation to said first latch hook (72) and said first latch slot (74),
wherein said second latch hook (72') is located on said connecting member (76) or extends from a rear plate (32') at an opposite end of said crate (10) in relation to said front plate (32) and said second latch slot (74') is located on one of the other of said connecting member (76) or said rear plate (32').

10. The crate (10) according to claim 9 wherein said connecting member (76) is substantially T-shaped.

11. The crate (10) of any one of claims 1-10, one of said body (20) and said front plate (32) being provided with an electromagnetically-sealing gasket (62) and the other of said body (20) and said front plate (32) being provided with an edge(64) fitting into said gasket (62), for electromagnetically sealing said front plate (32) or rear plate (32') to said body (20).

12. The electronics crate (10) of any one of claims 1-12, wherein said guiding track (38) has a variable slope along said guiding track (38).
